(19) Europäisches Patentamt / European Patent Office / Office européen des brevets

(11) **EP 4 752 928 A1**

(12) **EUROPEAN PATENT APPLICATION**

(43) Date of publication:
03.06.2026 Bulletin 2026/23

(21) Application number: 24216526.4

(22) Date of filing: 29.11.2024

(51) International Patent Classification (IPC):
*H01J 37/153* (2006.01)　　*H01J 37/21* (2006.01)

(52) Cooperative Patent Classification (CPC):
**H01J 37/153; H01J 37/21;** H01J 2237/1536;
H01J 2237/216

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: ASML Netherlands B.V.
5500 AH Veldhoven (NL)

(72) Inventors:
• **BARTHELEMY, Pierre**
**5500 AH Veldhoven (NL)**
• **BRADOSCHE PALLARES, Adrian**
**5500 AH Veldhoven (NL)**

(74) Representative: **ASML Netherlands B.V.**
**Corporate Intellectual Property**
**P.O. Box 324**
**5500 AH Veldhoven (NL)**

(54) **A METHOD, DEVICE, CHARGED PARTICLE-OPTICAL APPARATUS AND AN ASSESSMENT APPARATUS**

(57) The present invention provides a method of determining data representative of a focal surface of an array of charged particle beams and/or a height of a sample surface in a multi-beam charged particle-optical device, the method comprising: projecting beams onto a sample location at a first relative position; determining first individual focus values for individual beams; displacing the sample relative to the array of beams along a distance to a second relative position; determining second individual focus values for individual beams; displacing the sample relative to the array of beams along a distance to a third relative position; determining third individual focus values for individual beams in the array; and determining the data representative of the focal surface of the array of beams and/or the height of the sample surface based on the first individual focus values, the second individual focus values and the third individual focus values.

Fig. 11

**Description**

<u>FIELD</u>

The present invention relates to a method of determining data representative of a focal surface of an array of charged particle beams and/or a height of a sample surface, a method of calibrating a focal surface of an array of beams in a multi-beam charged particle system, a multi-beam charged particle-optical device, a charged particle-optical apparatus, and/or an assessment apparatus.

<u>BACKGROUND</u>

During manufacturing processes of, for example, semiconductor integrated circuit (IC) chips or displays, undesired defects may occur on a substrate (e.g. wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relates to defects, for example the existence and classification of such defects. Electron microscopes typically generate a probe beam (also often referred to as primary beam) which may, for example, be scanned across a part of the substrate (such as in a scanning electron microscopes (SEM)). Collecting interaction products that result from the interaction of the primary beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; the identification of defective structures may be referred to as (defect) inspection. The interaction products may contain charged particles which may be referred to as signal particles (e.g. signal electrons), such as secondary electrons and backscattered electrons, and may contain other interaction products, such as X-ray radiation and even light.

A multi-beam formed of multiple primary beams, e.g. an array of beams, may be used simultaneously. Such use of a multi-beam means that a sample (i.e. any inspection target, such as the substrate) can be assessed more quickly than when using a single-beam, as the multi-beam can scan different parts of the sample simultaneously. For example, a higher throughput of assessment may be achieved using a multi-beam assessment apparatus than a single beam apparatus.

In multi-beam systems (e.g. multi-beam SEM systems), it is desired to have at all times each beam focused on the sample. To achieve that goal, the focal surface of the multi-beam system may be calibrated, i.e. to optimize the Z position of the focal point of each e-beam to be as close as possible to a surface of the sample. To perform such a calibration, a known method is to measure the defocus between the beams and a reference sample surface, and to optimize the SEM parameters so that the defocus is minimized for all beams (i.e. to minimize the spread around zero). However, there may be inaccuracies in the focal point of each beam (i.e. a focal surface) relative to the surface of the sample. Thus, although some mechanisms for improving beam focus are known, the known mechanisms leave room for improvement. In particular, as advances are made to pattern smaller features on the substrate, it is even more important to determine data relating to the focal surface (and the sample surface) with a high level of accuracy.

It is an object of the present invention to provide a method and/or multi-beam charged particle-optical device (and/or an apparatus comprising the same) which at least partially addresses one or more of the problems of the prior art, whether identified herein or elsewhere.

<u>SUMMARY</u>

According to an aspect of the invention, a method of determining data representative of a focal surface of an array of charged particle beams and/or a height of a sample surface in a multi-beam charged particle-optical device is provided. The method comprising: projecting beams onto a sample location at a first relative position; determining first individual focus values for individual beams in the array at the sample location; displacing the sample relative to the array of beams along a distance to a second relative position; determining second individual focus values for individual beams in the array at the sample location; displacing the sample relative to the array of beams along a distance to a third relative position; determining third individual focus values for individual beams in the array at the sample location; and determining the data representative of the focal surface of the array of beams and/or the height of the sample surface based on the first individual focus values, the second individual focus values and the third individual focus values.

According to an aspect of the invention, a method of calibrating a focal surface of an array of beams in a multi-beam charged particle device is provided, comprising the above method, and further comprising calibrating the focal surface of the array of beams based on the determined data representative of the focal surface of the array of beams and/or the height of the sample surface.

According to an aspect of the invention, a multi-beam charged particle-optical device configured to direct an array of charged particle beams along respective beam paths towards a sample location is provided. The charged particle-optical device comprising: at least one beam directing element configured to direct the plurality of charged particle beams towards a sample location; a sample support configured to support a sample at the sample location; a positioning apparatus configured to move at least one of the sample and the directing element so as to displace the sample location relative to the array of beams along a distance; and a determination module configured to determine: first individual focus values for individual beams in the array at the sample location at a first relative position; second individual focus values for individual beams in the array at the sample location at a second relative position; third individual focus values for individual beams in the array at the sample location at a third relative position; and data representative of the focal surface of the array of beams and/or the height of the sample surface based on the first individual focus values, the second individual focus values and the third individual focus values.

According to an aspect of the invention, a charged particle-optical apparatus is provided comprising: the multi-beam charged particle optical device; and a source configured to emit at least one charged particle beam.

According to an aspect of the invention, an assessment apparatus for assessing a sample comprising: a vacuum chamber; and the multi-beam charged particle optical device, wherein at least part of the multi-beam charged particle optical device is in the vacuum chamber.

BRIEF DESCRIPTION OF THE DRAWINGS

Embodiments of the invention will now be described, by way of example only, with reference to the accompanying schematic drawings, in which:

- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a multi-beam charged particle-optical device, for example of the assessment apparatus of Figure 1;
- Figure 4 schematically depicts an alternative multi-beam charged particle-optical device, for example of the assessment apparatus of Figure 1;
- Figure 5 schematically depicts a charged particle-optical device array;
- Figure 6 schematically depicts an alternative multi-beam charged particle-optical device, for example of the assessment apparatus of Figure 1;
- Figure 7 schematically depicts an alternative multi-beam charged particle-optical device, for example of the assessment apparatus of Figure 1;
- Figure 8 schematically depicts part of the multi-beam charged particle-optical device of Figure 7;
- Figure 9 schematically depicts a detector array in plan view;
- Figure 10 schematically depicts a detector element in cross-section;
- Figure 11 schematically depicts primary beams directed towards the sample surface, showing a focal surface of the beams; and
- Figures 12A, 12B and 12C schematically depict displacement of the beams relative to the sample surface and the defocus between each beam and the sample surface in the different relative positions.

The figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device.

DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7-8%. It is desirable to determine defects quickly so as to maintain a high substrate throughput, defined as the number of substrates processed per hour.

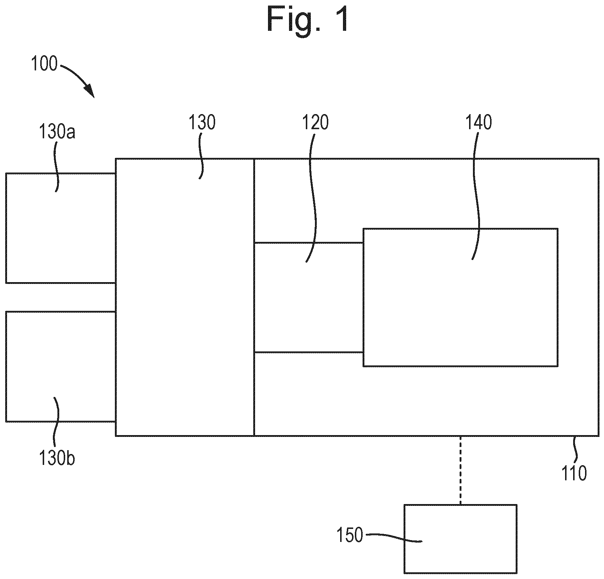

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus compared to a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

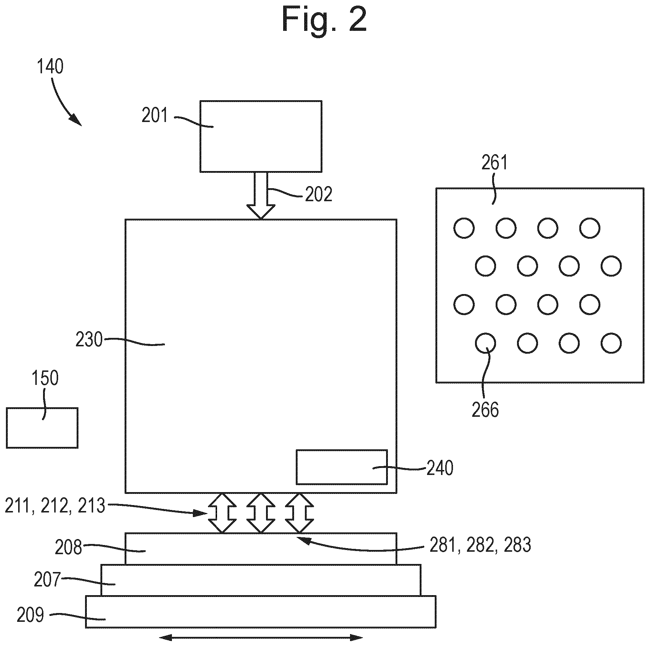

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208, which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

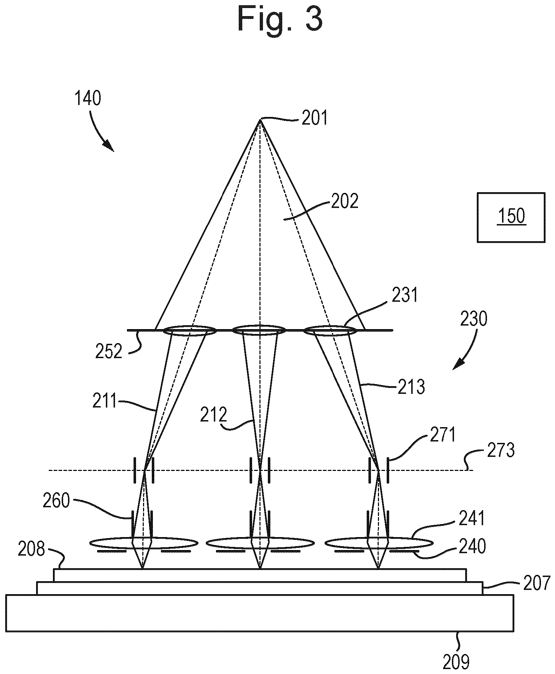

Figure 3 schematically depicts an electron-optical apparatus 140 of an assessment apparatus, e.g. the assessment apparatus 100 of Figure 1. The electron-optical apparatus 140 of Figure 3 may be the electron-optical apparatus 140 of Figure 2 in which the electron-optical elements of the electron-optical device 230 comprise a beam limiting aperture array 252, a condenser lens array 231, a collimator array 271 desirably at an intermediate focus plane 273, a scan deflector array 260, an objective lens array 241 and the detector array 240.

The source 201 generates a diverging source beam 202. The beam limiting aperture array 252 defines a plurality of primary beams 211, 212, 213 from the source beam 202. The condenser lens array 231 focuses the primary beams 211, 212, 213 at the intermediate focus plane 273. The condenser lens array 231 may comprise the beam limiting aperture array 252. Alternatively, the condenser lens array 231 may be downbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the primary beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective primary beams 211, 212, 213. Additionally or alternatively the collimator array 271 may comprise a lens array that operates on the different beams to deflect the relative paths of the beams. The collimator array 271 may be electrostatic. The collimator array 271 may consist of a single plate 261 comprising electrodes around the beam apertures 266, such as on the surface around the beam apertures 266 and/or on the inside of the beam apertures 266. The electrodes may cooperate as a deflector per beam aperture 266. Alternatively, the collimator array 271 may comprise a stack of plates 261. In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 3, in an alternative embodiment the collimator array 271 is replaced by a macro collimator configured to collimate the primary beams 211, 212, 213. The macro collimator may be a magnetic lens, or an electrostatic lens, or a combination of magnetic and electrostatic lens. In a further alternative embodiment, the electron-optical device 230 comprises a macro collimator in addition to the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the primary beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, e.g. between the condenser lens array and the collimator array.

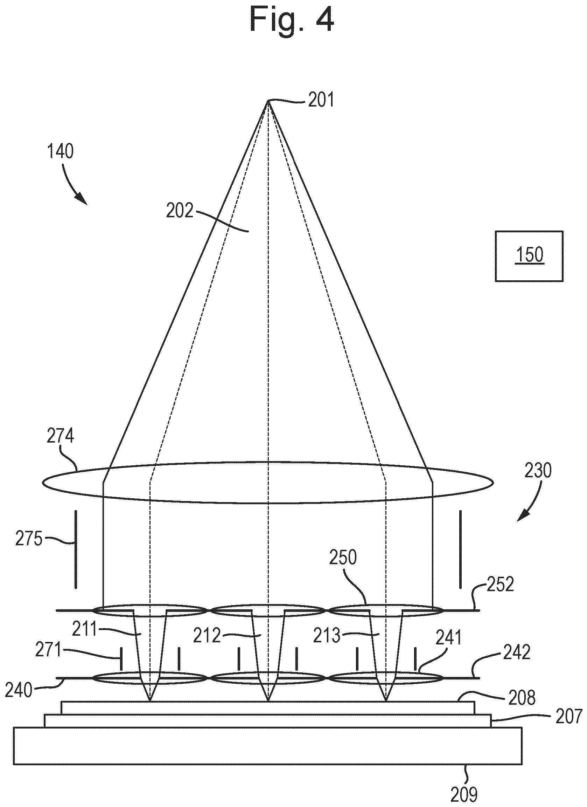

Figure 4 schematically depicts an electron-optical apparatus 140 of an assessment apparatus, e.g. the assessment apparatus 100 of Figure 1. The electron-optical apparatus 140 of Figure 4 may be the electron-optical apparatus 140 of Figure 2 in which the electron-optical device 230 comprises a macro condenser lens 274, a macro scan deflector 275, a beam limiting aperture array 252 (which may be referred to as an upper beam limiter), a control lens array 250, a collimator array 271, an objective lens array 241, a beam shaper array 242 (which may be referred to as a lower beam limiter) and the detector array 240.

The source 201 generates a diverging source beam 202. The macro condenser lens 274 is located between the source 201 and the objective lens array 241. The macro condenser lens 274 is configured to at least partly collimate the source beam 202. The macro scan deflector 275 is located between the macro condenser lens 274 and the objective lens array 241. The macro scan deflector 275 is configured to operate on the source beam 202 so that the primary beams 211, 212, 213 scan the surface of the sample 208. Additionally or alternatively the electron-optical device 230 may comprise a scan deflector array (not shown) downbeam of the control lens array 250. The macro condenser lens 274 and/or the macro scan deflector 275 may at least in part be magnetic.

The beam limiting aperture array 252 defines a plurality of primary beams 211, 212, 213 from the source beam 202. The beam shaper array 242 and the beam limiting aperture array 252 are plates 261 in which the beam apertures 266 are smaller in dimension than other plates of the electron-optical device 230. The beam apertures 266 of the beam limiting aperture array 252 define the primary beams 211, 212, 213. The beam apertures 266 of the beam shaper array 242 shape the primary beams 211, 212, 213 to at least partially correct for types of aberration in the beams.

The collimator array 271 is configured to collimate the primary beams 211, 212, 213 along respective beam paths towards and substantially orthogonal to a surface of the sample 208. The collimator array 271 may be located between the beam limiting aperture array 252 and the objective lens array 241. The collimator array 271 may be omitted. Alternatively, when the collimator array 271 is provided, then the macro condenser lens 274 may be omitted. The collimator array 271 may comprise a plurality of deflectors configured to deflect respective primary beams 211, 212, 213. The collimator array 271 may be electrostatic. The collimator array 271 may consist of a single plate 261 comprising the deflectors around the beam apertures 266, for example on the surface around the beam apertures 266 and/or on the inside of the beam apertures 266. Alternatively, the collimator array 271 may comprise a stack of plates 261. In use a potential difference is applied between the plates 261 so as to generate a lensing effect at the beam apertures 266. One or more of the plates may be curved across the path of the beam grid. Alternatively or additionally, the collimator array 271 may comprise a plurality of layers of strip electrode deflectors. A layer of strip electrode deflectors may be a plate.

The objective lens array 241 is configured to focus the primary beams 211, 212, 213 onto the sample 208. The objective lens array 241 may comprise a stack of plates 261. In use, different potentials may be applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The control lens array 250 may be upbeam of the objective lens array 241. The control lens array 250 may comprise a stack of plates 261, for example at least three plates 261. The control lens array 250 may be configured to control electron-optical parameters of the primary beams 211, 212, 213. In an embodiment, the most downbeam plate of the control lens array 250 is the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The stack of plates 261 of the objective lens array 241 may be referred to as an objective lens assembly. The objective lens assembly may comprise one or more of the beam limiting aperture array 252, the control lens array 250, a corrector array (not shown), the collimator array 271, the beam shaper array 242 and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, an objective lens array and a detector array are hereby incorporated by reference. The disclosure in WO2022058252 A1 of the collimator array, the macro condenser lens, the macro scan deflector, and the need for a beam limiting aperture array and a beam shaper array is incorporated by reference.

The electron-optical device 230 may comprise one or more corrector arrays (not shown) configured to at least partly correct one or more types of aberration of the beams. Such corrector arrays may be associated with or integrated into the control lens array 250, the collimator array 271 and/or the objective lens array 241, for example as part of the objective lens assembly.

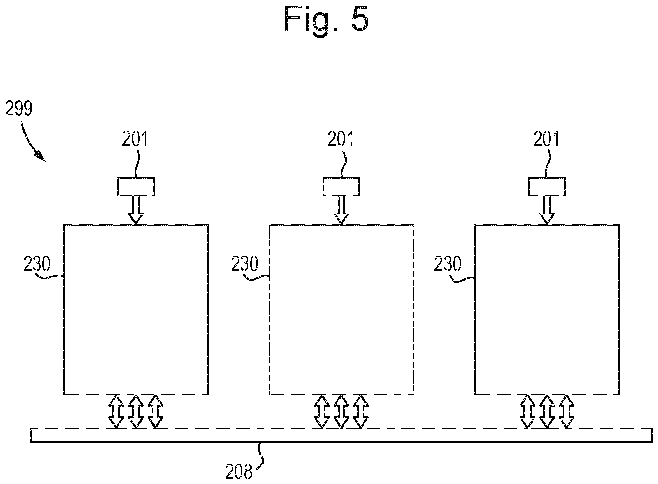

Figure 5 schematically depicts an electron-optical device array 299. In an embodiment the assessment apparatus 100 of Figure 1 comprises the electron-optical device array 299 instead of the electron-optical apparatus 140. Such an electron-optical device array 299 is also referred to as a multi-column array. The different columns (or electron-optical devices 230) may comprise in use a plurality of beams such as a beam grid. In an embodiment the electron-optical device array 299 comprises a plurality of electron-optical devices 230 of the type shown in Figure 2.

In an embodiment, one or more electron-optical elements may be shared between more than one of the electron-optical devices 230 of the electron-optical device array 299. The electron-optical elements may comprise one or more plates 261 in which a plurality of beam apertures 266 are defined for respective beam paths. In an embodiment, one or more sources 201 may be shared between more than one of the electron-optical devices 230 of the electron-optical device array 299. The sources may be comprised in a source array having different sources generating a source beam for different respective electron-optical device 230.

The electron-optical devices 230 may focus respective multi-beams simultaneously onto different regions of the same sample 208. In a different embodiment, the electron-optical devices 230 of the electron-optical device array 299 may project respective single beams towards the sample 208.

Each electron-optical device 230 of the electron-optical device array 299 may be configured in any of the ways described herein. The disclosure in WO 2022008286 A1 of how the objective lens is incorporated and adapted for use in the multi-device arrangement is hereby incorporated by reference. The disclosure in WO 2021165135 A1 of a multi-device arrangement of a multi-beam device comprising a collimator at, or proximate to, an intermediate focus is hereby incorporated by reference.

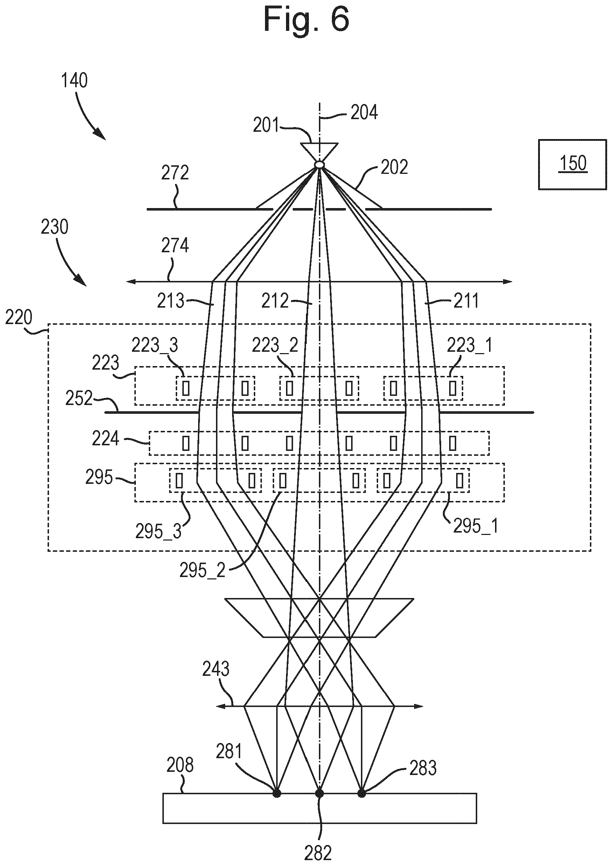

Figure 6 schematically depicts an electron-optical apparatus 140 of an assessment apparatus, e.g. the assessment apparatus 100 of Figure 1. The electron-optical apparatus 140 comprises an electron-optical device 230. The field of view of the electron-optical device 230 may be, for example, of the order of 100s of microns across the primary beams 211, 212, 213 at the sample 208. The electron-optical apparatus 140 of Figure 6 may be the electron-optical apparatus 140 of Figure 2 in which the electron-optical device 230 comprises a Coulomb aperture array 272, a macro condenser lens 274, a source converter (or micro-optical array) 220 and an objective lens 243. The electron-optical apparatus 140 defines an electron-optical axis 204. The Coulomb aperture array 272 may be referred to as a beam former array.

The source 201 generates a source beam 202. The Coulomb aperture array 272 defines a plurality of primary beams 211, 212, 213 from the source beam 202. The Coulomb aperture array 272, in operation, is configured to block off peripheral electrons to reduce electron-electron interactions (also referred to as Coulomb interactions) that may generate aberrations.

The macro condenser lens 274 is configured to at least partly collimate the primary beams 211, 212, 213. In an embodiment the macro condenser lens 274 is magnetic. The macro condenser lens 274 may be a non-rotational condenser lens. In an embodiment the macro condenser lens 274 is configured to operate on a plurality of, optionally all of, the primary beams 211, 212, 213.

The source converter 220 is configured to convert the primary beams 211, 212, 213 transmitted by the Coulomb aperture array 272 into the beams that are directed towards the sample 208. In an embodiment the source converter 220 is a module. Alternatively, the source converter 220 may comprise a plurality of separate electron-optical elements.

In an embodiment the source converter 220 comprises a pre-bending deflector array 223 with pre-bending deflectors 223_1, 223_2, 223_3 configured to deflect respective primary beams 211, 212, 213 toward a beam limiting aperture array 252.

In an embodiment the source converter 220 comprises a beam limiting aperture array 252 with an aperture pattern (i.e. apertures arranged in a formation) configured to define the outer dimensions of the primary beams 211, 212, 213 directed towards the sample 208. The beam limiting aperture array 252 may be a plate 261. In an embodiment, the beam limiting aperture array 252 defines a plurality of beams from each of the primary beams 211, 212, 213 directed to the beam limiting aperture array 252. In an alternative embodiment, the beam limiting aperture array 252 maintains the number of the primary beams 211, 212, 213 incident on the beam limiting aperture array 252.

The source converter 220 may comprise a corrector array such as an aberration reduction array 224 configured to reduce aberrations of the primary beams 211, 212, 213. In an embodiment the aberration reduction array 224 comprises a plurality of lenses configured to operate on respective primary beams 211, 212, 213. The aberration reduction array 224 may, for example, comprise a field curvature compensator array (not shown) comprising lenses. The aberration reduction array 224 may comprise an astigmatism compensator array (not shown) comprising stigmators. The stigmators may, for example, be controlled to operate on the primary beams 211, 212, 213 to reduce astigmatism aberrations.

The source converter 220 may comprise a deflector array 295 comprising deflectors 295_1, 295_2, 295_3 for the beam paths of respective primary beams 211, 212, 213. The deflectors 295_1, 295_2, 295_3 are configured to deflect the beam paths of the primary beams 211, 212, 213 towards the front focal plane of the objective lens 243 to ensure that the individual primary beams 211, 212, 213 will impinge on the sample 208 substantially perpendicular.

In an embodiment the objective lens 243 is magnetic. In an embodiment the objective lens 243 is a macroscopic lens configured to manipulate a plurality of, optionally all of, the primary beams 211, 212, 213 simultaneously. The objective lens 243 focuses the primary beams 211, 212, 213 onto the surface of the sample 208. The primary beams 211, 212, 213 form respective probe spots 281, 282, 283 on the surface of the sample 208. The deflectors 295_1, 295_2, 295_3 of the deflector array 295 deflect the individual primary beams 211, 212, 213 to the front focal plane of the objective lens to ensure that the individual primary beams 211, 212, 213, in use, impinge on the substrate 208 substantially perpendicular. In an embodiment the objective lens 243 is a macroscopic lens containing both magnetic and electrostatic lenses. In such an embodiment the macroscopic electrostatic lenses manipulate the plurality of the primary beams 211, 212, 213 simultaneously. In a further embodiment, the objective lens 243 comprises one or more scan deflectors (electrostatic and/or magnetic) to scan the plurality of primary beams 211, 212, 213 over the substrate 208.

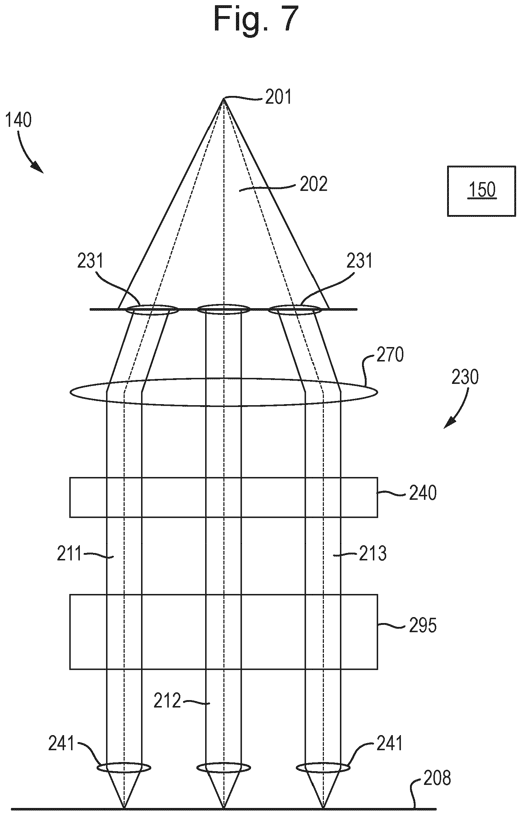

Figure 7 schematically depicts an electron-optical apparatus 140 of an assessment apparatus, e.g. the assessment apparatus 100 of Figure 1. The electron-optical apparatus 140 may be the electron-optical apparatus 140 of Figure 2 in which the electron-optical device 230 comprises a condenser lens array 231, a macro collimator 270, the detector array 240, a deflector array 295 and an objective lens array 241.

Features that are the same as those described above are given the same reference numerals. For conciseness, such features are not described in detail with reference to Figure 7. For example, the source 201, the condenser lens array 231, the objective lens array 241 and the sample 208 may be as described above.

The source is configured to generate a source beam 202. The condenser lens array 231 is configured to define a plurality of primary beams 211, 212, 213 from the source beam 202. The disclosure in EP1602121A1 of a lens array to split a beam into a plurality of beams, with the lens array providing a lens for each beam, is hereby incorporated by reference as a possible implementation of the condenser lens array 231.

In an embodiment the condenser lens array 231 comprises three plates 261 configured as an Einzel lens. An Einzel lens is configured to substantially ensure that the energy of an electron leaving the lens is the same as when the electron arrived at the lens. Such a lens maintains the energy of an electron between arriving and leaving the lens, for example the condenser lenses of the condenser lens array 231. Thus, dispersion only occurs within the condenser lens array 231 itself, thereby limiting chromatic aberrations. When a distance between the three plates of the Einzel lens is small, the chromatic aberrations caused by this condenser lens array 231 is limited, e.g. having a negligible effect.

In an embodiment the electron-optical device 230 comprises a collimator which may be macro collimator 270. The macro collimator 270 bends respective beams by an amount effective to ensure that a beam axis of each of the primary beams 211, 212, 213 derived from the primary 202 beam is incident on the sample 208 substantially normally (i.e. at substantially 90° to the nominal surface of the sample 208). In the current embodiment, the macro collimator 270 acts on all of the primary beams 211, 212, 213. The macro collimator 270 may comprise an electrostatic lens and/or a magnetic lens arrangement comprising a plurality of lens elements (e.g. a plurality of electrostatic and/or magnetic elements, e.g. forming a multipole).

In an embodiment the detector array 240 is configured to detect signal electrons by reference to the energy of the signal electron. For example, scintillators e.g. YAG do not directly detect electrons but generate light which is then detected. The signal electrons emitted from the sample 208 gain energy from the electromagnetic fields between the detector array 240 and the sample 208. In an embodiment, the objective lens array 241 is located between the detector array 240 and the sample 208.

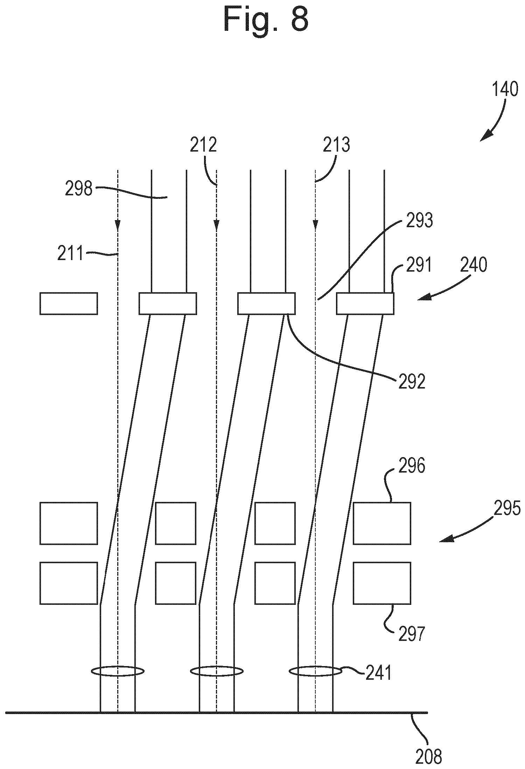

The electron-optical device 230 may comprise a deflector array 295 located between the detector array 240 and the objective lens array 241. The deflector array 295 may be referred to as a beam separator. The deflector array 295 may deflect signal electrons resulting from individual primary beams 211, 212, 213 along a path towards detector elements of a detector array 240 that is away from the paths of the primary beams towards the sample 208. The deflector array 295 may comprise a magnetic deflector array that is configured to provide magnetic fields to disentangle the primary electrons projected toward the sample 208 from the signal (e.g. secondary) electrons emitted from the sample 208. The deflector array 295 may comprise a Wien filter array. The deflector array 295 may comprise an electrostatic deflector array that is arranged to cooperate with the magnetic deflector array to achieve the disentangling of the paths of the primary electrons and signal electrons. Figure 8 is a close-up view of part of the electron-optical device 230 shown in Figure 7. In an embodiment the detector array 240 comprises an electron to photon converter array 291, e.g. a scintillator array. The electron to photon converter array 291 comprises a plurality of fluorescent elements (e.g. comprising YAG) which may be in the form of fluorescent strips 292 extending across the beam grid. Each fluorescent strip 292 is located in the plane of the electron to photon converter array 291. At least one fluorescent strip 292 is arranged between two adjacent primary beams 211, 212, 213 projected towards the sample 208. In an embodiment, the fluorescent strips 292 extend substantially across the beam grid. Alternatively, the electron to photon converter array 291 may comprise a plate of a fluorescent material with openings 293 for the primary beams 211, 212, 213 or an array of elements of similar size around the beams and that may be spaced apart. The primary beams 211, 212, 213 are projected through the plane of the electron to photon converter array 291, e.g. via the openings 293 such as between the fluorescent strips 292, towards the deflector array 295.

In an embodiment the deflector array 295 comprises a magnetic deflector 296 and an electrostatic deflector 297. The electrostatic deflector 297 is configured to counteract the deflection of the magnetic deflector 296 for the primary beams 211, 212, 213 transmitted towards the sample 208. Accordingly, the primary beams 211, 212, 213 may be shifted to a small extent in the horizontal plane. The beam paths downbeam of the deflector array 295 are substantially parallel to the beam paths upbeam of the deflector array 295.

In an embodiment the objective lens array 241 comprises a plurality of plates for guiding signal electrons emitted from the sample 208 towards the deflector array 295. For the signal electrons, which travel in opposite direction with respect to the projected primary beams 211, 212, 213, the electrostatic deflector 297 does not counteract the deflection of the magnetic deflector 296. Instead, the deflections of the secondary electrons by the electrostatic deflector 297 and the magnetic deflector 296 add up. Accordingly, the signal electrons are deflected to travel at an angle with respect to the optical axis in order to transmit the secondary electrons onto the fluorescent strips 292 of the detector array 240.

At the fluorescent strips 292, photons are created upon incidence of the signal electrons. In an embodiment, the photons are transported from the fluorescent strip 292 to a photo detector (not shown) via a photon transport unit. In an embodiment, the photon transport unit comprises an array of optical fibers 298. Each optical fiber 298 comprises an end which is arranged adjacent or attached to one of the fluorescent strips 292 for coupling photons from the fluorescent strip 292 into the optical fiber 298, and another end which is arranged to project photons from the optical fiber 298 onto the photo detector. In a different arrangement, the optical to electrical converter (or photo diode) is located immediately adjacent the electron to light converter, avoiding the need for optical fibers.

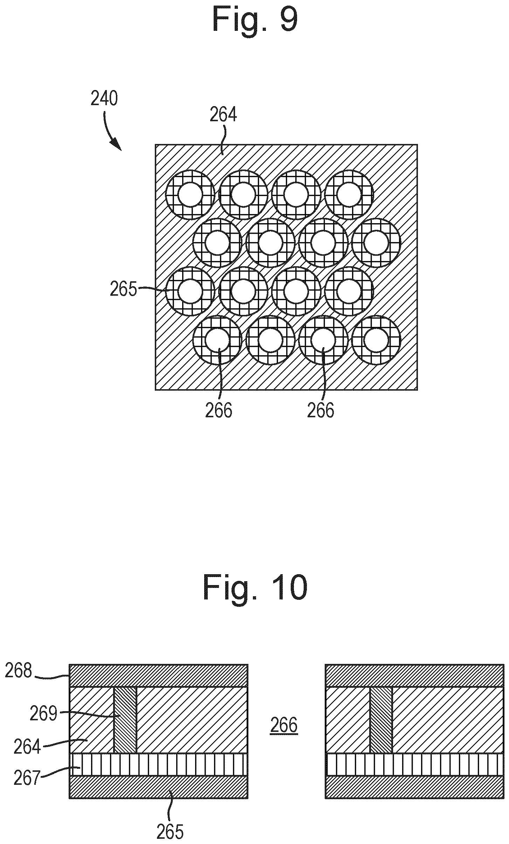

Figure 9 is a bottom view of the detector array 240 which comprises a detector substrate 264 on which are provided a plurality of detector elements 265 each surrounding a beam aperture 266. The detector array 240 may be provided at a downbeam surface of a plate 261 comprising beam apertures 266. In an embodiment, the detector elements 265 are charge capture electrodes, for example metal plates. The beam apertures 266 may be formed by etching through the detector substrate 264. In the arrangement shown in Figure 9, the beam apertures 266 are in a hexagonal close packed array. The beam apertures 266 can also be differently arranged, e.g. in a rectangular array.

Figure 10 depicts at a larger scale a part of the detector array 240 in cross section. The detector elements 265 form the bottom surface, i.e. the surface the closest to the sample 208, of the detector array 240. Between the detector elements 265 and the main body of the detector substrate 264 a logic layer 267 may be provided. At least part of the signal processing system, for example for amplification, may be incorporated into the logic layer 267.

A wiring layer 268 is provided on the backside of, or within, the detector substrate 264 and connected to the logic layer 267 by through-substrate vias 269. The number of through-substrate vias 269 need not be the same as the number of beam apertures 266. In particular if the electrode signals are digitized in the logic layer 267 only a small number of through-silicon vias may be required to provide a data bus. The wiring layer 268 may include control lines, data lines and power lines. It will be noted that in spite of the beam apertures 266 there is ample space for all necessary connections. The detector array 240 may be fabricated using CMOS technology, but may also be fabricated using bipolar or other manufacturing techniques. A printed circuit board and/or other semiconductor chips may be provided on the detector array 240.

In an embodiment the electron-optical apparatus 140 comprises a secondary electron-optical device comprising the detector array 240. In such an embodiment a beam separator typically is arranged to deflect the path of the signal electrons towards the secondary electron-optical device. The secondary electron-optical device subsequently directs the signal electrons towards the detector array 240 and focuses the signal electrons (e.g. secondary electrons) onto the detector array 240.

In an embodiment any electron-optical element or group of electron-optical elements may be replaceable or field replaceable within the electron-optical apparatus 140. Field replaceability means that the electron-optical element or group of electron-optical elements may be replaced without substantially disassembling the electron-optical apparatus 140. In an embodiment the electron-optical apparatus 140 comprises at least one module. Each module comprises a group of adjacent electron-optical elements. The electron-optical elements of a module may be secured to each other, for example as a stack.

Features in electron-optical plates may be manufactured using techniques from microelectromechanical systems (MEMS) (i.e. using MEMS manufacturing techniques). MEMS are miniaturized mechanical and electromechanical elements that are made using microfabrication techniques. Merely as an example, a collimator array may be formed using MEMS manufacturing techniques so as to be spatially compact. As another example, a scan deflector array may be formed using MEMS manufacturing techniques.

In an embodiment, the assessment apparatus 100 comprises a plurality of position sensors. The position sensors may be or comprise level sensors. The position sensors may be capacitive sensors and/or differential sensors. The position sensors may be positioned on a surface of an electron-optical element (e.g. a detector array) of the electron-optical apparatus 140. The surface may be configured to face the sample 208. The position sensors may be positioned around and away from the beam paths. In an embodiment, the position sensors are connected to the ground potential. In an embodiment, electronics associated with the position sensors are connected to the ground potential. In an embodiment the position sensors are configured to output signals to the controller 150. The position sensors may be operated to determine the position of the sample surface and a facing surface of the electron-optical device relative to each other.

An electric power source may be provided to supply power to the assessment apparatus 100 and/or electron-optical apparatus 140. For example, such a power supply may apply respective potentials to electrodes of lenses of the electron-optical device 230.

In an embodiment, the controller 150 is configured to control the electron-optical device 230. The controller 150 may be configured to control potentials applied to electrodes of lenses of the electron-optical device 230.

In an embodiment the controller 150 is configured to control the actuatable stage 209 to move the sample 208 during inspection of the sample 208. The controller 150 may enable the actuatable stage 209 to move the sample 208 in a direction, for example continuously, such as at a constant speed, at least during sample inspection, which may be referred to as a type of scanning. The speed of the actuatable stage 209 may be referred to as the moving rate. The controller 150 may control movement of the actuatable stage 209 so as to change the speed of movement of the sample 208 relative to the beam paths dependent on one or more parameters. The controller 150 may control deflection of scan deflectors so that the beam paths move relative to the actuatable stage 209 and thus over the surface of the sample 208. The controller 150 may change a beam deflection of a scan deflector and thus the scanning of the primary beams 211, 212, 213 over the sample 208 dependent on one or more parameters. For example, the controller 150 may control a scan deflector and/or the speed of the actuatable stage 209 and/or the direction of movement of the actuatable stage 209 depending on characteristics of the assessment process. The disclosure in EP4086933 A1 of a combined stepping and scanning strategy of the stage and scanning deflectors is hereby incorporated by reference. The moving rate may at different times comprise a stepping frequency and/or a stage scanning rate.

The electron-optical device 230 may be provided as a column. The column may comprise an objective lens assembly. Optionally the electron-optical device 230 comprise the source 201. Alternatively, the source 201 may be separate from the electron-optical device 230. The electron-optical apparatus 140 may be locatable on an apparatus footprint in a chip fabrication facility. Environmental conditioning systems and processors such as process/data racks may be remote from the part of the electron-optical apparatus 140 present on the apparatus footprint. Such environmental conditioning systems may comprise part of a thermal conditioning system and part of a vacuum system.

In an embodiment the electron-optical apparatus 140 comprises one or more liner tubes (not shown). The liner tube is for shielding the beam paths from external fields, for example when the source 201 is at a higher potential than the sample 208 relative to a ground potential. The liner tube may extend between different components of the electron-optical apparatus 140. For example, a liner tube may extend between the source 201 and an upbeam surface of a stack of plates 261 which forms an objective lens array. The liner tube, if spaced away from the objective lens array and at a different potential from a facing surface of the objective lens array may provide a lensing function.

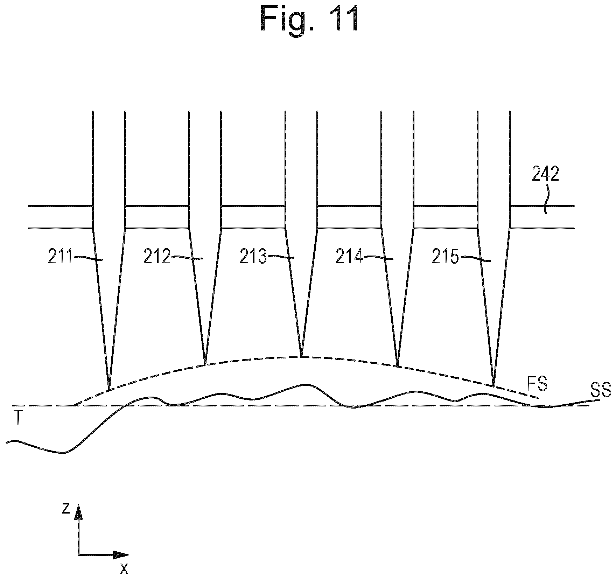

As described above, the use of multiple beams in a charged particle-optical device is beneficial in that the sample (e.g. any inspection target, such as the substrate) may be assessed more quickly than when using a single-beam. However, this may present an issue in focusing each of the beams on the sample at all times. It is known that there are inaccuracies in the focal point of each beam relative to the sample in known systems. This is shown in figure 11, in which the focal point of each of the primary beams 211, 212, 213, 214, 215 do not form a horizontal plane (as might be ideal so as to coincide with an ideal sample surface T), but instead are provided at varying heights. The focal points of the primary beams form focal surface FS. Furthermore, the focal point of each of the primary beams are not incident on the sample surface SS. Thus, there is a need for determining data relating to the focal surface FS with a higher level of accuracy.

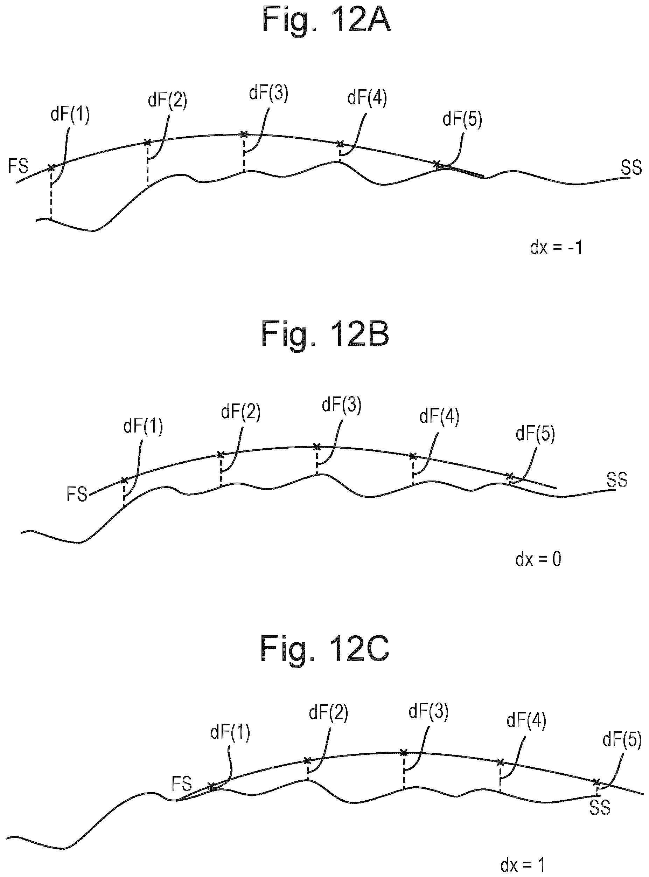

It will be noted that figure 11 includes five primary beams, compared to previous figures which include only three primary beams 211, 212, 213. Any appropriate number of primary beams may be provided, for example as described above, number of beams may be of the order of 100s or 1,000s, for example up to 20,000. However, the additional beams are shown in figures 11 and 12A-C to more clearly show the discrepancy between the focal surface FS and the sample surface SS, and how the present invention provides a method for determining relevant data relating to the focal surface FS and/or sample surface SS.

Additionally, the inventors have noted that the surface of the sample (i.e. the sample surface SS) may not be flat. There is a benefit in determining data relating to the height of the sample surface so that any variations can be accounted for. In particular, if the height of the surface is not known, and particularly any variation in the height of the surface, this can increase inaccuracies in focusing the multiple beams. Thus, there is a benefit in not only determining variations in height of the sample surface, but also accounting for such variations in any subsequent calibration of the focal surface FS. Accounting for the sample surface SS reduces or removes contribution of inaccuracy due to the sample surface in the determination of the focal surface FS. In this way, determination of the defocus between the focus of the beams and the surface of the sample can be optimized.

The present invention involves making a series of measurements of a defocus map. In other words, measurements of the defocus of a number of beams are taken at each of multiple relative locations, wherein the sample surface SS can be moved relative to the beams between different relative locations. Data representative of the focal surface FS and/or a height of the sample surface SS can be calculated from the defocus measurements taken. If the displacements between relative locations are such that the defocus of each e-beam is measured multiple times, one can calculate separately the contribution to defocus of the focal position of each beam (which does not change with the sample displacement) and of the target topography below each beam (which changes with the sample displacement). Thus, the measurements can be used to determine the focal surface FS and/or the sample surface SS. More particularly, the method allows for removal of the impact of the sample surface shape in the focal surface determination allowing for improved accuracy.

In currently developed multi-beam SEM systems, variation in the height of a wafer can already have an impact of the order of 50-100 nm on the defocus measurement, and hence on the calibration of the focal surface FS. The present method (described below) allows for removal of this contribution to the focus budget, and then gain a 50-100 nm accuracy on the focal surface determination.

In an embodiment, a method is provided of determining data representative of a focal surface FS of an array of charged particle beams and/or a height of a sample surface SS in a multi-beam charged particle-optical device. In this embodiment, the data representative of the focal surface FS and/or the height of the sample surface SS is the actual height of the focal surface FS and/or the height of the sample surface SS at a location respectively. Thus, the method is used to determine the focal surface FS of an array of charged particle beams in a multi-beam charged particle-optical device and/or a height of a sample surface SS in a multi-beam charged particle-optical device. The actual position of the focal surface FS and/or height of the sample are provided relative to a reference point. The reference point may be known as a reference "zero" point. The reference point can be determined from a reference measurement. For instance, the reference point can be the "zero" of one of the position sensors, that has been calibrated earlier to give a specific reading at a known location.

The method comprises determining individual focus values for individual beams at multiple relative positions, wherein the sample is displaced relative to the array of beams between the determining step at each relative position. In further detail, the method comprises projecting beams onto a sample location at a first relative position. For example, the beams may be projected onto the sample using any device or apparatus as herein described, for example, at least part of the electron-optical apparatus 140 or electron-optical device 230. The method comprises determining first individual focus values for individual beams in the array at the sample location at the first relative position. The method comprises displacing the sample relative to the array of beams along a distance to a second relative position and determining second individual focus values for individual beams in the array at the sample location, and displacing the sample relative to the array of beams along a distance to a third relative position and determining third individual focus values for individual beams in the array at the sample location. The method further comprises determining the data representative of the focal surface FS of the array of beams and/or the height of the sample surface SS based on the first individual focus values, the second individual focus values and the third individual focus values.

The method allows measurements to be taken of the individual beams at a number of different locations relative to the sample. The determination of the focus values relies on the measurements taken. The series of focus values determined can be resolved (e.g. using matrix equations) to calculate the position of the focal surface FS and/or height of the sample.

The individual focus values may be determined for each of the beams projected onto the sample at a given relative position. Alternatively, individual focus values may be determined for a subset of beams projected onto a sample at a given relative position. In other words, it is not necessary to determine focus values for each and every beam projected onto the sample, even though this may be preferable. However, if focus values are determined for a given beam at a given relative position, then the focus value for that beam should be determined at the other relative positions, so long as the beam is incident on the sample at that relative position. In other words, the focus values are to be determined for selected beams at different relative positions. The greater the number of beams for which the individual focus values are determined may be beneficial in improving accuracy of the representative data determined.

Determining individual focus values for individual beams at a given relative position may comprise determining a defocus value for each individual beam in a direction parallel to said beam. Thus, the defocus value is representative of the difference, in a direction parallel to a given beam (i.e. in the Z direction in figure 11), between the focal point for that beam and the sample surface SS at the point at which that beam is incident. The defocus value is represented by the difference in height between the focal surface FS and the sample surface SS, labelled dF(X) in figures 12A-12C, where "X" indicates the specific beam.

The defocus value may be determined in any appropriate way. For example only, the defocus value may be determined by taking an image of the beams at the sample location at a plurality of positions for a given relative position, wherein the plurality of positions are displaced from each other in a direction parallel to the beams, and determining from the images the defocus value along each individual beam.

In further detail, the image of a beam can be taken by deflecting the beam to sweep the deflecting beam along an "X" axis, and use a detector to detect signal particles (e.g. secondary electrons). By making N detections during the sweep time, you get N pixels of one row of the image. Then you step along to another relative position (e.g. by making a displacement in the "Y" direction) and start sweeping in "X" axis again to acquire the second row, and so on until you have all rows of pixels in the image at a given height "Z" (i.e. at a given position parallel to the beam). The image can be taken at another height, i.e. at a different position parallel to the beam by moving the detector and/or sample relative to each other in the direction parallel to the beams. Thus, an image can be taken at different positions along each individual beam, i.e. at different heights, e.g. at different Z positions in figure 11.

The defocus may be determined from the images in various ways, e.g. using different algorithms. For example, for each image, it is possible calculate a certain key performance indicator that correlates with the sharpness of the image. For example, the key performance indicator may be image variance or it may be based on the amplitude of the high frequency contents of the image. The calculated key performance will vary at different positions parallel to the beam. Thus, the position parallel to the beam (e.g. in the Z direction) can be determined at which the key performance indicator is optimized, indicating the "best focus" relative to the sample surface SS. Thus, the defocus for each beam may be determined based on the displacement parallel to the beam between the position of "best focus" for a given beam and the sample surface SS.

Other methods of determining the defocus values are also available. For example, it is also possible to determine focus by varying the field strength of an appropriate lens element (electrostatic or magnetic). The method works as in a photo-camera: in a photo camera, you may either move the subject closer or further from the camera so that it is in the zone that is in-focus, or you may tweak the objective of the camera to move the zone that is in-focus to where the subject is. In the multi-beam system, the defocus may be determined in a similar ways, i.e. by moving the sample until it reaches the focus, as well as by changing the potential difference or current applied to at least one plate 261, to move the focal point of the beams up and/or down until they match with the sample position. In both cases, the way we determine defocus is the same: we see if the image is sharp or not. The difference being we reach the "best focus" i.e. the settings where the focal point of the beam is at the sample, either by moving the sample up and down, or by changing the settings of the lens to move the focal point up and down.

Thus, the individual focus values are determined at each of the relative positions using the above, or other known methods. Thus, the method determines at least first individual focus values, second individual focus values and third individual focus values. For example only, displacement between the first, second and third relative position may be parallel to each other, for example in the X direction in figures 11 and 12, and the direction of displacement between the relative positions may be substantially orthogonal to the beams. An individual focus value may be the defocus value measured for a given beam at a relative position.

As shown in figure 12A, measurements may be taken in the first relative position when the beams are incident on the sample surface SS. In this case, the first defocus value may be represented as $dF(X, dx = -1)$, which is indicative of the defocus of each beam at the first relative position.

The sample may be displaced relative to the beams by a distance substantially equal to at least one pitch between the beams at the sample location in the respective direction. For example, in this case by stepping the sample a distance substantially equal to a multitude of the pitch in the direction of displacement, in this case a distance substantially equivalent to the pitch between beams in the X direction. The displacement between the first relative position and the second relative position is in a first direction.

For example, as shown in figure 12B, measurements may be taken in a second relative position when the beams are incident on the sample surface SS. In this case, the second defocus value may be represented as $dF(X, dx = 0)$, which is indicative of the defocus of each beam at the second relative position.

The sample may be displaced relative to the beams by a distance substantially equal to at least one pitch between the beams at the sample location in the respective direction. For example, in this case by stepping the sample a distance substantially equal to a multitude of the pitch in the direction of displacement, in this case a distance substantially equivalent to the pitch between beams in the X direction. The displacement between the second relative position and the third relative position is in a second direction. The first direction and the second direction may be parallel to each other, for example as shown in figures 12A, 12B and 12C.

For example, as shown in figure 12C, measurements may be taken in a third relative position when the beams are incident on the sample surface SS. In this case, the third defocus value may be represented as $dF(X, dx = 1)$, which is indicative of the defocus of each beam at the third relative position.

For example, in relation to a first beam (for example corresponding to beam 211), the defocus $dF(1, dx = -1)$ can be measured at the first reference position as shown in figure 12A, the defocus $dF(1, dx = 0)$ can be measured at the second reference position as shown in figure 12B, and the defocus $dF(1, dx = 1)$ can be measured at the third reference position as shown in figure 12C. Similarly, defocus values for the second beam (for example corresponding to beam 212) at each of the reference positions are indicated by dF(2), defocus values for the third beam (for example corresponding to beam 213) at each of the reference positions are indicated by dF(3), defocus values for the fourth beam (for example corresponding to beam 214) at each of the reference positions are indicated by dF(4), and defocus values for the fifth beam (for example corresponding to beam 215) at each of the reference positions are indicated by dF(5).

The defocus values at a given point is equivalent to the height of the focal surface FS at that point, i.e. the location of the focal point parallel to the beam e.g. in the Z direction in figures 11-12C, minus the height of the sample surface SS at that point. Thus, the defocus values for a given beam can be represented by the following equations, namely equations (1), (2) and (3):

$$dF(X, dx = -1) = Zf(X) - Zt(X - 1) \tag{1}$$

$$dF(X, dx = 0) = Zf(X) - Zt(X) \tag{2}$$

$$dF(X, dx = 1) = Zf(X) - Zt(X + 1) \tag{3}$$

Where dF is the defocus, Zf is the height of the focal surface FS, and Zt the height of the sample. The focus of the individual beams remains substantially constant during relative displacement of the sample. Thus, the focal position, i.e. Zf(X), of each beam does not change for that beam between the different relative positions. We have then 3*N equations (where N is the number of beams) with 2N variables. Well known methods can be used to resolve the above equations, for example using known matrix methods, i.e. using an inverse matrix/standard least square method, to provide both the shape of the focal surface FS and the shape of the sample surface SS. This information may be used in a number of ways.

When determining the data representative of the focal surface FS and/or the surface height by resolving the equations as described above, the displacement distance between relative positions is an order of magnitude of the pitch.

Determining data representative of the focal surface FS is particularly useful when multiple beams are provided (i.e. at least two beams) and individual control of the focus of each beam is not available.

Providing more accurate determination of the focal shape and/or shape of the sample surface SS may be particularly beneficial in calibrating the focal surface FS. In an embodiment, a method is provided of calibrating the focal surface FS of the array of beams in a multi-beam charged particle device based on the determined data representative of the focal surface FS of the array of beams and/or the height of the sample surface SS. Thus, the focal surface FS can be calibrated using the determined focal surface FS and/or sample surface height calculated using the method described herein. Such a method therefore allows for the impact of the sample surface SS on the focal surface determination and calibration to be reduced, or even removed, allowing for improved accuracy.

Determination of the focal shape and/or shape of the sample surface SS locally of the sample may be particularly beneficial, because the focal surface may be adapted to more closely match the local height and curvature of the sample surface SS. For example, the focal surface FS may be adjusted based on the determined focal surface FS to adjust the average location and/or curvature of the focal surface, e.g. to provide a focal surface FS closer to the sample surface SS. This can be based on the sample surface SS as determined, or may be applied to other sample surfaces, particularly if other sample surfaces are known (which may have been determined via a different method). The adjustment of the focal surface FS may be based on an average height of the focal surface FS for the beams used in the determination, i.e. the total sum of the heights of each beam as determined divided by the number of beams used for the determination. The adjustment of the focal surface FS may be based on best fit, e.g. minimizing the sum of the squares of the difference between the determined focal surface FS and the determined sample surface SS. Adjustment of the focal surface FS may be based on the focal surface FS determined in other ways.

If the device for projecting the beams onto the sample allows for adjustment of the focus of individual beams, then the focus of individual beams could be adjusted based on the determined focal height to provide the focal point at a desired height for each beam. If the device for projecting the beams onto the sample allows for adjustment of the focus of a group of beams, then the focus of the group of beams could be adjusted based on the determined focal height of any beams included in that group, e.g. based on an average focal height of the beams in that group. Thus, there may be local adaptation of the focus of a subset of beams.

In some devices, the focus of the beams is controlled together, i.e. there is no individual control of the focus of the beams. For example, the beams may be projected onto the sample location using at least one lens array comprising at least two electrodes positioned along primary beam paths of the array of beams. Each of the electrodes having an aperture corresponding to at least one beam, and through which the at least one beam passes. Calibrating the focal surface FS of the array of beams may thus comprise adjusting a potential applied to the at least one of the electrodes. The use of such electrodes allows for controlling both the position and curvature of the beams. The at least two electrodes may be part of the objective lens array 241. At least one additional electrode may be used, for example, to optimize other beam properties also. Each electrode may correspond to one of the stack of plates 261 shown in figure 2.

In the above described embodiment, the direction of displacement between the first relative position and the second relative position is substantially orthogonal to the beams and the direction of displacement between the second relative position and third relative position is substantially orthogonal to the beams. This is shown by the change in relative position between figures 12A and 12B, and between figures 12B and 12C. The displacement may be substantially orthogonal, rather than exactly orthogonal, as the systems can cause the beams to slightly tilt back-and-forth while scanning. Thus, the displacement is generally kept within a plane of movement which is substantially orthogonal to the beams.

In the above described embodiment, the first direction and the second direction are parallel to each other. However, this is not a necessity. The first direction may be different from the second direction. For example, the first direction and the second direction may be orthogonal. This may be particularly useful for an array in which the beams are in a square array. For example, an angle formed between the first direction and the second direction, for example in a plane orthogonal to the beams, is approximately 60° or 120 °. This may be particularly useful for an array in which the beams are in a hexagonal array.

In the above embodiment, the distance displaced between the first relative position and the second relative position (i.e. the first distance) is substantially equivalent to the pitch between beams at the sample location (i.e. incident on the sample surface SS) in the direction of displacement. In the above embodiment, the distance displaced between the second relative position and the third relative position (i.e. the second distance) is substantially equivalent to the pitch between beams at the sample location in the direction of displacement. More generally, the first distance and/or the second distance may be substantially equal to any multitude of the pitches in the direction of displacement, i.e. one pitch, two pitches, three pitches, four pitches or more. Preferably, the first distance and/or the second distance is substantially equal to three times the pitch, or even more. The first distance and the second distance may be substantially the same, e.g. may both be substantially equivalent to three pitches, but this is not a necessity and they could be different multitudes of the pitch.

Additional measurements can be taken to those described above. Although the above describes determining focus values at three relative positions, it will be understood that at least one additional determination can be made at another relative position, with a corresponding additional displacement between each further relative position. In further detail, the method may further comprise displacing the sample relative to the array of beams along a distance to at least one additional relative position, determining further individual focus values for individual beams in the array at the sample location at each at least one additional relative position, and determining the data representative of the focal surface FS and/or the height of the sample surface SS using the further individual focus values. Determining the focus values at additional relative positions is beneficial in improving the accuracy of the focal surface FS and/or the height of the sample determined.

In the above embodiment, the method is used to determine the focal surface FS and/or sample height, i.e. the representative data is the actual focal surface FS and/or sample height. Although this is beneficial in the degree of accuracy that can be provided, it is noted that in some instances, particularly for example when it is only possible to calibrate the focal surface FS collectively for all the beams together rather than individually or in sub-groups, such a degree of accuracy may be even higher than needed.

In an alternative embodiment, assumptions can be made relying on a model of the shape of the focal surface FS and/or the sample surface SS. For example, assumptions can be made so as to determine a second order shape representative of the focal surface FS and/or sample surface SS, which may for example, be adjusted by the systems described above. In this embodiment, the representative data is a model determined based on the first, second and third individual focus values. For example, the model may be the equivalent of an equation indicative of the shape, e.g. a second order equation representative of the shape. For example only, the model may be represented by equation (4):

$$z = ax^2 + by^2 \qquad\qquad (4)$$

It will be noted that features of the present embodiment may be same as features of the previous embodiment (including any of the variations described) in which the representative data is the actual height of the focal surface FS and/or the height of the sample surface SS at a location. For example, the data may be used for calibration as described above. The defocus may be determined as described above. Additional measurements may be taken as described above. Only differences between the embodiments will be described below.

In further detail, the method comprises providing a model of an estimated focal surface FS of the array of beams and/or the height of the sample surface SS. For example, the model may be an equation representative of a parabola which may be used for the focal surface FS and/or sample surface SS. Determining the representative data comprises adjusting the model based on the first individual focus values, the second individual focus values and the third individual focus values, for example, to adapt parameters of the equation based on the determined values. The use of such a model can be beneficial if we are only interested, for instance, in the second order shape of the focal surface FS, for example if the data is being used for calibration and the extent of calibration is limited to account for the second order shape.

The type of model can be based on assumptions and/or physical knowledge already determined by other methods, for example, of the shape of the surface. For instance, it may be known that the contribution to the shape which can be adjusted for by the device has a second order shape. For example, an assumption can be made that the focal surface FS has a shape $z = ax^2 + by^2$. In this example, the measurements and the derived equations then only need to recover the parameters a and b (compared to determining additional values for all individual beams described above when determining the actual focal surface FS and/or sample height).

Additionally, the use of the model is beneficial in that there is greater freedom in selecting the first distance and/or the second distance. The first distance and/or the second distance may be the same as described in the above embodiment. However, other options may be available due to the assumptions involved in using the model. The first distance and/or the second distance may be a value other than a magnitude of the pitch.

For example, the displacement between relative positions may be less than the pitch between beams at the sample location in the direction moved. More specifically, the first distance (between the first relative position and the second relative position) and/or the second distance (between the second relative position and the third relative position) can be less than one pitch between the beams at the sample location in the respective direction. In this case, the first direction may preferably be different from the second direction, although this is not a requirement for example, when the model is as shown in equation (4).

Additionally, the measurements carried out for the method using such model preferably overlap, i.e. at least two measurements should be taken at one specific location on the sample. In other words, measurements are preferably taken using two different beams at one location, for example, a measurement via one beam when in the first relative position and another measurement at the same spot on the sample via another beam when in the second relative position.

In an embodiment, a multi-beam charged particle-optical device (for example as in any of the embodiments or variations described herein) is provided which is configured to carry out the methods described above.

The present invention provides a multi-beam charged particle-optical device which is configured to direct an array of charged particle beams along respective beam paths towards a sample location. The multi-beam charged particle-optical device may be the same as the electron-optical device 230 described above.

The charged particle-optical device comprises at least one beam directing element configured to direct the plurality of charged particle beams towards the sample location. The at least one beam directing element may be any component described above which interacts with at least one of the beams of the array of beams to assist in directing the at least one beam towards the sample location. For example, the beam directing element could be any of the condenser lens array 231, collimator array 271, scan deflector array 260, macro condenser lens 274, macro-scan deflector 275, the beam limiting aperture array 252, control lens array 250, beam shaper array 242 and/or the objective lens array 241.

The charged particle-optical device comprises a sample support configured to support a sample at the sample location. The sample support may be the same as the sample holder 207 described above.

The charged particle-optical device comprises a positioning apparatus configured to move at least one of the sample and the directing element so as to displace the sample location relative to the array of beams along a distance. Preferably, the sample is moved and the directing element is kept stationary. The positioning apparatus may be the same as the actuatable stage 209 described above.

The positioning apparatus is configured to displace the sample between the relative positions, i.e. between the first relative position, the second relative position and the third relative position. The positioning apparatus may be configured to move at least one of the sample and the directing element to at least one additional relative position. The displacement between relative positions may be as described above.

The charged particle-optical device comprises a determination module configured to determine first individual focus values for individual beams in the array at the sample location at a first relative position, second individual focus values for individual beams in the array at the sample location at a second relative position, and third individual focus values for individual beams in the array at the sample location at a third relative position. The determination module may be configured to determine further individual focus values for individual beams in the array at the sample location at any additional relative positions.

Furthermore, the determination module is configured to determine data representative of the focal surface FS of the array of beams and/or the height of the sample surface SS based on the first individual focus values, the second individual focus values and the third individual focus values (as well as any further individual focus values from any additional relative positions if relevant). The data representative of the focal surface FS and/or height of the sample surface SS may be the actual values or a model of the values, as described in the above embodiments.

The determination module may be provided as part of the controller 150. Alternatively, the determination module could be provided by a separate controller. Different aspects of the determination carried out by the determination module may be carried out in different controllers, e.g. positioned in different places, but which are in communication so as to provide the relevant values for determining the representative data.

As described in the method above, determining individual focus values for individual beams at a given relative position may comprise determining a defocus value for each individual beam in a direction parallel to said beam, e.g. in a Z direction in figures 11-12C. The charged particle-optical device may comprise at least one detector for taking an image of the beams for determining a defocus value. In further detail, the detector may be configured to detect signal particles to obtain an image of the beams at the sample location at a plurality of positions at a given relative position, wherein the plurality of positions are displaced from each other in a direction parallel to the beam (e.g. at different heights). The determination module may be configured to determine the defocus value along an individual beam from the images. The at least one detector could be provided by any of the detector elements (e.g. detector elements 265) and/or detector arrays 240.

The charged particle-optical device may be configured to calibrate the focal surface FS of the array of beams based on the determined data representative of the focal surface FS of the array of beams, for example, as described above. The at least one beam directing element may comprise at least two electrodes positioned along primary beam paths of the array of beams, and calibrating the focal surface FS of the array of beam may comprise adjusting a potential applied to the at least one of the electrodes. The at least two electrodes may be part of the objective lens array 241. At least one additional electrode can be used, for example, to optimize other beam properties also. Each electrode may correspond to one of the stack of plates 261 shown in figure 2.

In an embodiment, the multi-beam charged particle-optical device described above may be part of a charged particle-optical apparatus. The charged particle-optical apparatus may be the same as the electron-optical apparatus 140. The multi-beam charged particle-optical apparatus comprises a source configured to emit at least one charged particle beam. The source may be the same as the source 201 described above.

In an embodiment, the multi-beam charged particle-optical device described above may be part of an assessment apparatus for assessing the sample. The assessment apparatus may be the same as the assessment apparatus 100. The assessment apparatus may comprise a vacuum chamber. The vacuum chamber may be the same as the vacuum chamber 110 described above. At least part of the multi-beam charged particle optical device is positioned within in the vacuum chamber. Preferably at least the beam directing element, sample support and positioning apparatus are providing within the vacuum chamber. At least part of the determination module may be outside of the vacuum chamber. For example, the controller 150 may be configured to provide the determination module, which may be positioned outside of the vacuum chamber. The determination module could be provided by a separate controller.

In an embodiment, the multi-beam charged particle-optical device described above may be part of a charged particle-optical device array, for example, the electron-optical device array 299.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other substrate) or mask (or other patterning device).

Although specific reference may have been made above to the use of embodiments of the invention in the context of sample assessment, it will be appreciated that the invention, where the context allows, is not limited to sample assessment and may be used in other applications, for example electron beam lithography.

Where the context allows, embodiments of the invention may be implemented in hardware, firmware, software, or any combination thereof. For example, at least the determination module included in embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions.

However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Embodiments include the following numbered clauses:

Clause 1: a method of determining data representative of a focal surface of an array of charged particle beams and/or a height of a sample surface in a multi-beam charged particle-optical device, the method comprising:

projecting beams onto a sample location at a first relative position;
determining first individual focus values for individual beams in the array at the sample location;
displacing the sample relative to the array of beams along a distance to a second relative position;
determining second individual focus values for individual beams in the array at the sample location;
displacing the sample relative to the array of beams along a distance to a third relative position;
determining third individual focus values for individual beams in the array at the sample location; and
determining the data representative of the focal surface of the array of beams and/or the height of the sample surface based on the first individual focus values, the second individual focus values and the third individual focus values.

Clause 2: the method according to clause 1, wherein a direction of displacement between the first relative position and the second relative position is substantially orthogonal to the beams and/or a direction of displacement between the second relative position and third relative position is substantially orthogonal to the beams.

Clause 3: the method according to either one of the preceding clauses, wherein the data representative of the focal surface and/or the height of the sample surface is the actual height of the focal surface and/or the height of the sample surface at a location.

Clause 4: the method according to either one of clauses 1 or 2, wherein the method comprises providing a model of an estimated focal surface of the array of beams and/or the height of the sample surface and determining the representative data comprises adjusting the model based on the first individual focus values, the second individual focus values and the third individual focus values.

Clause 5: the method according to any one of the preceding clauses, wherein the displacement between the first relative position and second relative position is in a first direction and the displacement between the second relative position and the third relative positions is in a second direction, wherein the first direction is different from the second direction.

Clause 6: the method according to any one of clauses 1 to 4, wherein the displacement between the first relative position and second relative position is in a first direction and the displacement between the second relative position and the third relative positions is in a second direction, wherein the first direction and the second direction are parallel to each other.

Clause 7: the method according to any one of the preceding clauses, wherein the distance of the displacement between the first relative position and the second relative position and/or the distance of the displacement between the second relative position and the third relative position is substantially equal to at least one pitch between the beams at the sample location in the respective direction.

Clause 8: the method according to clause 7, wherein the distance of the displacement between the two relative positions is substantially equal to a multitude of the pitch in the direction of displacement.

Clause 9: the method according to clause 8, wherein the distance of the displacement is substantially equal to three times the pitch.

Clause 10: the method according to clause 4, wherein the distance of the displacement between the first relative position and the second relative position and/or the distance of the displacement between the second relative position and the third relative position is less than one pitch between the beams at the sample location in the respective direction and

the displacement between the first relative position and second relative positions is in a first direction and the displacement between the second relative position and the third relative positions is in a second direction, wherein the first direction is different from the second direction.

Clause 11: the method according to any one of the preceding clauses, wherein the method comprises:

displacing the sample relative to the array of beams along a distance to at least one additional relative position;
determining further individual focus values for individual beams in the array at the sample location at each at least one additional relative position; and
determining the data representative of the focal surface and/or the height of the sample surface using the further individual focus values.

Clause 12: the method according to any one of the preceding clauses, wherein determining individual focus values for individual beams at a given relative position comprises determining a defocus value for each individual beam in a direction parallel to said beam.

Clause 13: the method according to clause 12, wherein determining a defocus value comprises: taking an image of the beams at the sample location at a plurality of positions for a given relative position, wherein the plurality of positions are displaced from each other in a direction parallel to the beams, and determining from the images the defocus value along each individual beam.

Clause 14: a method of calibrating a focal surface of an array of beams in a multi-beam charged particle device, the method comprising any one of the preceding clauses, and further comprising calibrating the focal surface of the array of beams based on the determined data representative of the focal surface of the array of beams and/or the height of the sample surface.

Clause 15: the method of clause 14, wherein the beams are projected onto the sample location using at least one lens array comprising at least two electrodes positioned along primary beam paths of the array of beams, and calibrating the focal surface of the array of beams comprises adjusting a potential applied to the at least one of the electrodes.

Clause 16: a multi-beam charged particle-optical device configured to direct an array of charged particle beams along respective beam paths towards a sample location, the charged particle-optical device comprising:

at least one beam directing element configured to direct the plurality of charged particle beams towards a sample location;
a sample support configured to support a sample at the sample location;
a positioning apparatus configured to move at least one of the sample and the directing element so as to displace the sample location relative to the array of beams along a distance; and
a determination module configured to determine:

first individual focus values for individual beams in the array at the sample location at a first relative position;
second individual focus values for individual beams in the array at the sample location at a second relative position;
third individual focus values for individual beams in the array at the sample location at a third relative position; and
data representative of the focal surface of the array of beams and/or the height of the sample surface based on the first individual focus values, the second individual focus values and the third individual focus values.

Clause 17: the device according to clause 16, wherein a direction of displacement between the first relative position and the second relative position is substantially orthogonal to the beams and/or a direction of displacement between the second relative position and third relative position is substantially orthogonal to the beams.

Clause 18: the device according to either one of clauses 16 or 17, wherein the data representative of the focal surface and/or the height of the sample surface is the actual height of the focal surface and/or the height of the sample surface at a location.

Clause 19: the device according to either one of clauses 16 to 18, wherein the determination module is configured to provide a model of an estimated focal surface of the array of beams and/or the height of the sample surface and is configured to determine the representative data by adjusting the model based on the first individual focus values, the second individual focus values and the third individual focus values.

Clause 20: the device according to any one of clauses 16 to 19, wherein the displacement between the first relative position and second relative position is in a first direction and the displacement between the second relative position and the third relative positions is in a second direction, wherein the first direction is different from the second direction.

Clause 21: the device according to any one of clauses 16 to 19, wherein the displacement between the first relative position and second relative position is in a first direction and the displacement between the second relative position and the third relative positions is in a second direction, wherein the first direction and the second direction are parallel to each other.

Clause 22: the device according to any one of clauses 16 to 21, wherein the distance of the displacement between the first relative position and the second relative position and/or the distance of the displacement between the second relative position and the third relative position is substantially equal to at least one pitch between the beams at the sample location in the respective direction.

Clause 23: the device according to clause 22, wherein the distance of the displacement between the two relative positions is substantially equal to a multitude of the pitch in the direction of displacement.

Clause 24: the device according to clause 23, wherein the distance of the displacement is substantially equal to three times the pitch.

Clause 25: the device according to clause 19, wherein the distance of the displacement between the first relative position and the second relative position and/or the distance of the displacement between the second relative position and the third relative position is less than one pitch between the beams at the sample location in the respective direction and

the displacement between the first relative position and second relative positions is in a first direction and the displacement between the second relative position and the third relative positions is in a second direction, wherein the first direction is different from the second direction.

Clause 26: the device according to any one of clauses 16 to 25, wherein the positioning apparatus is configured to displace the sample relative to the array of beams along a distance to at least one additional relative position; and the determination module is configured to:

determine further individual focus values for individual beams in the array at the sample location at each at least one additional relative position; and

determine the data representative of the focal surface and/or the height of the sample surface using the further individual focus values.

Clause 27: the device according to any one of clauses 16 to 26, wherein determining individual focus values for individual beams at a given relative position comprises determining a defocus value for each individual beam in a direction parallel to said beam.

Clause 28: the device according to clause 27, further comprising a detector configured to detect signal particles to obtain an image of the beams at the sample location at a plurality of positions at a given relative position, wherein the plurality of positions are displaced from each other in a direction parallel to the beams, and wherein the determination module is configured to determine from the images the defocus value along each individual beam.

Clause 29: the device according to any one of clauses 16 to 28, further configured to calibrate the focal surface of the array of beams based on the determined data representative of the focal surface of the array of beams.

Clause 30: the device of clause 29, further comprising at least one beam directing element comprises at least two electrodes positioned along primary beam paths of the array of beams, and calibrating the focal surface of the array of beams comprises adjusting a potential applied to the at least one of the electrodes.

Clause 31: a charged particle-optical apparatus comprising:

the multi-beam charged particle optical device of any one of clauses 16 to 30; and
a source configured to emit at least one charged particle beam.

Clause 32: an assessment apparatus for assessing a sample comprising:

a vacuum chamber; and
the multi-beam charged particle optical device of any one of clauses 16 to 30 wherein at least part of the multi-beam charged particle optical device is in the vacuum chamber.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

List of reference numerals:

100 assessment apparatus
110 vacuum chamber (main chamber)
120 load lock chamber
124 gun aperture
125 beam limit aperture
130 EFEM
130a first loading port
130b second loading port
132a pole piece
132b control electrode
132c deflector

132d exciting coil
135 column aperture
140 electron-optical apparatus (electron beam apparatus, electron apparatus)
148 first multipole lens
150 controller
158 second multipole lens
201 source
202 source beam
204 electron-optical axis
207 sample holder
208 sample
209 actuatable stage
211, 212, 213, 214, 215 primary beams (sub-beams, beamlets)
220 source converter (micro-optical array)
223 pre-bending deflector array
224 aberration reduction array
230 electron-optical device (electron-optical column)
231 condenser lens array
240 detector array
241 objective lens array
242 beam shaper array
243 objective lens
250 control lens array
252 beam limiting aperture array
260 scan deflector array
261 plate
264 detector substrate
265 detector elements
266 beam apertures
267 logic layer
268 wiring layer
269 through-substrate vias
270 macro collimator
271 collimator array
272 Coulomb aperture array
273 intermediate focus plane
274 macro condenser lens
275 macro scan deflector
281-283 probe spots
291 photon converter array
292 fluorescent strip
293 openings
295 deflector array
296 magnetic deflector
297 electrostatic deflector
298 optical fiber
299 electron-optical device array
FS focal surface
SS sample surface
T ideal sample surface

**Claims**

1. A method of determining data representative of a focal surface of an array of charged particle beams and/or a height of a sample surface in a multi-beam charged particle-optical device, the method comprising:

projecting beams onto a sample location at a first relative position;

determining first individual focus values for individual beams in the array at the sample location;
displacing the sample relative to the array of beams along a distance to a second relative position;
determining second individual focus values for individual beams in the array at the sample location;
displacing the sample relative to the array of beams along a distance to a third relative position;
determining third individual focus values for individual beams in the array at the sample location; and
determining the data representative of the focal surface of the array of beams and/or the height of the sample surface based on the first individual focus values, the second individual focus values and the third individual focus values.

2. The method according to claim 1, wherein a direction of displacement between the first relative position and the second relative position is substantially orthogonal to the beams and/or a direction of displacement between the second relative position and third relative position is substantially orthogonal to the beams.

3. The method according to either one of the preceding claims, wherein the data representative of the focal surface and/or the height of the sample surface is the actual height of the focal surface and/or the height of the sample surface at a location.

4. The method according to either one of claims 1 or 2, wherein the method comprises providing a model of an estimated focal surface of the array of beams and/or the height of the sample surface and determining the representative data comprises adjusting the model based on the first individual focus values, the second individual focus values and the third individual focus values.

5. The method according to any one of the preceding claims, wherein the displacement between the first relative position and second relative position is in a first direction and the displacement between the second relative position and the third relative positions is in a second direction, wherein the first direction is different from the second direction, or wherein the first direction and the second direction are parallel to each other.

6. The method according to any one of the preceding claims, wherein the distance of the displacement between the first relative position and the second relative position and/or the distance of the displacement between the second relative position and the third relative position is substantially equal to at least one pitch between the beams at the sample location in the respective direction.

7. The method according to claim 6, wherein the distance of the displacement between the two relative positions is substantially equal to a multitude of the pitch in the direction of displacement.

8. The method according to any one of the preceding claims, wherein the method comprises:

displacing the sample relative to the array of beams along a distance to at least one additional relative position;
determining further individual focus values for individual beams in the array at the sample location at each at least one additional relative position; and
determining the data representative of the focal surface and/or the height of the sample surface using the further individual focus values.

9. The method according to any one of the preceding claims, wherein determining individual focus values for individual beams at a given relative position comprises determining a defocus value for each individual beam in a direction parallel to said beam.

10. The method according to claim 9, wherein determining a defocus value comprises:
taking an image of the beams at the sample location at a plurality of positions for a given relative position, wherein the plurality of positions are displaced from each other in a direction parallel to the beams, and determining from the images the defocus value along each individual beam.

11. A method of calibrating a focal surface of an array of beams in a multi-beam charged particle device, the method comprising any one of the preceding claims, and further comprising calibrating the focal surface of the array of beams based on the determined data representative of the focal surface of the array of beams and/or the height of the sample surface.

12. A multi-beam charged particle-optical device configured to direct an array of charged particle beams along respective beam paths towards a sample location, the charged particle-optical device comprising:

at least one beam directing element configured to direct the plurality of charged particle beams towards a sample location;

a sample support configured to support a sample at the sample location;

a positioning apparatus configured to move at least one of the sample and the directing element so as to displace the sample location relative to the array of beams along a distance; and

a determination module configured to determine:

first individual focus values for individual beams in the array at the sample location at a first relative position;

second individual focus values for individual beams in the array at the sample location at a second relative position;

third individual focus values for individual beams in the array at the sample location at a third relative position; and

data representative of the focal surface of the array of beams and/or the height of the sample surface based on the first individual focus values, the second individual focus values and the third individual focus values.

13. The device according to claim 12, wherein the data representative of the focal surface and/or the height of the sample surface is the actual height of the focal surface and/or the height of the sample surface at a location.

14. The device according to claim 12, wherein the determination module is configured to provide a model of an estimated focal surface of the array of beams and/or the height of the sample surface and is configured to determine the representative data by adjusting the model based on the first individual focus values, the second individual focus values and the third individual focus values.

15. A charged particle-optical apparatus comprising:

the multi-beam charged particle optical device of any one of claims 12 to 14; and

a source configured to emit at least one charged particle beam.

# Fig. 1

# Fig. 2

# Fig. 3

# Fig. 4

# Fig. 5

# Fig. 6

# Fig. 7

# Fig. 8

# Fig. 9

# Fig. 10

# Fig. 11

## Fig. 12A

dF(1)   dF(2)   dF(3)   dF(4)   dF(5)

FS

SS

dx = -1

## Fig. 12B

dF(1)   dF(2)   dF(3)   dF(4)   dF(5)

FS

SS

dx = 0

## Fig. 12C

dF(1)   dF(2)   dF(3)   dF(4)   dF(5)

FS

SS

dx = 1

## EUROPEAN SEARCH REPORT

**Application Number**

EP 24 21 6526

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 4 439 626 A1 (IMS NANOFABRICATION GMBH [AT]) 2 October 2024 (2024-10-02) ----- | 1-15 | INV. H01J37/153 H01J37/21 |
| A | US 2016/300689 A1 (TROMP RUDOLF M [US]) 13 October 2016 (2016-10-13) ----- | 1-15 | |
| A | EP 4 303 908 A1 (ASML NETHERLANDS BV [NL]) 10 January 2024 (2024-01-10) ----- | 1-15 | |

**TECHNICAL FIELDS SEARCHED (IPC)**

H01J

The present search report has been drawn up for all claims

| Place of search | Date of completion of the search | Examiner |
|---|---|---|
| Munich | 9 May 2025 | Oestreich, Sebastian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 21 6526

This annex lists the patent family members relating to the patent documents cited in the above-mentioned European search report.
The members are as contained in the European Patent Office EDP file on
The European Patent Office is in no way liable for these particulars which are merely given for the purpose of information.

09-05-2025

| Patent document cited in search report | Publication date | Patent family member(s) | Publication date |
|---|---|---|---|
| EP 4439626 A1 | 02-10-2024 | EP 4439626 A1<br>JP 2024127863 A<br>KR 20240137485 A<br>US 2024304415 A1 | 02-10-2024<br>20-09-2024<br>20-09-2024<br>12-09-2024 |
| US 2016300689 A1 | 13-10-2016 | CN 106057619 A<br>US 2016300688 A1<br>US 2016300689 A1 | 26-10-2016<br>13-10-2016<br>13-10-2016 |
| EP 4303908 A1 | 10-01-2024 | NONE | |

EPO FORM P0459

For more details about this annex : see Official Journal of the European Patent Office, No. 12/82

**EP 4 752 928 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2022101072 A1
- WO 2012165955 A
- WO 2021156121 A1
- WO 2021204734 A1
- EP 23211553
- WO 2021156121 A
- WO 2021204734 A
- WO 2004081910 A
- EP 3869535 A1
- WO 2021165136 A1
- WO 2022058252 A1
- WO 2022008286 A1
- WO 2021165135 A1
- EP 1602121 A1
- EP 4086933 A1